# EUROPÄISCHE PATENTSCHRIFT

(11) **EP 2 126 972 B1**
(45) Veröffentlichungstag und Bekanntmachung des Hinweises auf die Patenterteilung: **14.11.2012**
(21) Anmeldenummer: 08706748.4
(22) Anmeldetag: 11.01.2008
(51) Int. Cl.: H01L 27/02, H01L 31/173, H01L 29/737

(54) **Verfahren zur Selbstüberwachung des Durchbruchs in Halbleiterbauteilen sowie dafür ausgebildetes Halbleiterbauteil**
Method for self-monitoring the breakdown in semiconductor components and semiconductor component adapted thereto
Procédé d'auto-surveillance de la rupture de composants à semi-conducteur et composant à semi-conducteur conçu à cet effet

(30) Priorität: 19.01.2007 DE 102007002820
(43) Veröffentlichungstag der Anmeldung: 02.12.2009
(73) Patentinhaber: Universität Stuttgart, 70174 Stuttgart (DE)
(72) Erfinder: KASPER, Erich, 89284 Pfaffenhofen (DE); MORSCHBACH, Michael, 70180 Stuttgart (DE)
(74) Vertreter: Gagel, Roland
(86) Internationale Anmeldenummer: PCT/DE2008/000047
(87) Internationale Veröffentlichungsnummer: WO 2008/086776

(56) Entgegenhaltungen:
- JP-A- 2 159 995
- US-A- 6 097 748
- US-B1- 6 233 127
- CHATTERJEE A ET AL: "Reversible light coalescence phenomena of Si photo-emitters under stressing at low breakdown currents" SOLID STATE ELECTRONICS, ELSEVIER SCIENCE PUBLISHERS, BARKING, GB, Bd. 47, Nr. 4, 1. April 2003 (2003-04-01), Seiten 665-670, XP004408718 ISSN: 0038-1101
- BAR-LEV A ET AL: "Measurements on light emission and current distribution in avalanching epitaxial diodes" IEEE TRANSACTIONS ON ELECTRON DEVICES USA, Bd. ED-21, Nr. 8, August 1974 (1974-08), Seiten 537-539, XP002481557 ISSN: 0018-9383
- KERNS D V ET AL: "Comparison of Contactless Measurement and Testing Techniques to a New All-Silicon Optical Test and Characterization Method" IEEE TRANSACTIONS ON INSTRUMENTATION AND MEASUREMENT, IEEE SERVICE CENTER, PISCATAWAY, NJ, US, Bd. 54, Nr. 5, 1. Oktober 2005 (2005-10-01), Seiten 2082-2089, XP011140133 ISSN: 0018-9456

## Beschreibung

### Technisches Anwendungsgebiet

Die vorliegende Erfindung betrifft ein Verfahren zur Überwachung des Durchbruchs von pn-Übergängen in Halbleiterbauteilen sowie ein für die Anwendung des Verfahrens ausgebildetes Halbleiterbauteil. Ein Halbleiterbauteil kann dabei ein oder mehrere Halbleiterbauelemente, wie bspw. Dioden oder Transistoren, umfassen. Das Verfahren eignet sich vor allem für die Selbstüberwachung des Durchbruchs in schnellen integrierten Schaltungen (ICs) und in schnellen Halbleiterbauelementen.

### Stand der Technik

Schnelle integrierte Schaltungen und schnelle Halbleiterbauelemente weisen einen frühen Durchbruch auf. Mit dem Begriff Durchbruch wird in der vorliegenden Patentanmeldung der Lawinendurchbruch an einem pn-Übergang bezeichnet, der ab einer gewissen, am pn-Übergang angelegten Spannung oder ab einer gewissen elektrischen Feldstärke (kritische Feldstärke) in der Raumladungszone auftritt. Durch den frühen Durchbruch ergibt sich für diese ICs und Halbleiterbauelemente ein stark eingeschränkter Betriebsbereich.

Bislang kann der Durchbruch nur durch externe Spannungs- oder Strombegrenzung verhindert werden. Eine derartige feste Begrenzung muss jedoch frühzeitig einsetzen, um individuelle Schwankungen in den elektrischen Eigenschaften des Halbleiterbauteils und Temperatureffekte zu berücksichtigen. Dies verkleinert den Betriebsbereich des Halbleiterbauteils zusätzlich und verringert dadurch die Leistungsausschöpfung. Der Durchbruch kann das Bauelement und die integrierte Schaltung zerstören.

Die US-2006/0194382 A1 offenbart ein Verfahren zur Erstellung einer ESD-Schutzschaltung für ein Halbleiterbauteil, die in das Halbleiterbauteil integriert ist. Zur Bestimmung der für die Erstellung der Schutzschaltung erforderlichen Parameter wird eine physikalische Analyse der Elemente der Schutzschaltung durchgeführt, die unter anderem eine Messung der Durchbruchcharakteristik eingesetzter MOSFET sowie eine Analyse der Photoemission umfasst.

Die US 6097748 A beschreibt einen VCSEL mit einem integrierten Photodetektor zur automatischen Leistungskontrolle des Lasers. Der Photodetektor erfasst dabei die vom Laser am pn-Übergang emittierte Strahlung, um über den injizierten Strom die Ausgangsleistung des Lasers zu regeln.

CHATTERJEE A et al., "Reversible light coalescence phenomena of Si photo-emitters under stressing at low breakdown currents", SOLID STATE ELECTRONICS, ELSEVIER SCIENCE PUBLISHERS, BARKING, GB, Bd. 47, Nr. 4, 1, April 2003 (2003-04-01), Seiten 665-670, und BAR-LEV A et al., "Measurements on light emission and current distribution in avalanching epitaxial diodes", IEEE TRANSACTION ON ELECTRON DEVICES USA, Bd. ED-21, Nr. 8, August 1974 (1974-08), Seiten 537-539, untersuchen die schwache Lichtemission beim Durchbruch eines pn-Übergangs unter unterschiedlichen Randbedingungen.

### Darstellung der Erfindung

Die Aufgabe der vorliegenden Erfindung besteht darin, ein Echtzeitverfahren zur Überwachung des Durchbruchs von pn-Übergängen in Halbleiterbauteilen sowie ein für die Durchführung des Verfahrens ausgebildetes Halbleiterbauteil anzugeben, das einen vergrößerten Betriebsbereich des Halbleiterbauteils ermöglicht.

Die Aufgabe wird mit dem Verfahren und dem Halbleiterbauteil gemäß den Patentansprüchen 1 und 7 gelöst. Vorteilhafte Ausgestaltungen des Verfahrens sowie des Halbleiterbauteils sind Gegenstand der Unteransprüche oder lassen sich der nachfolgenden Beschreibung sowie dem Ausführungsbeispiel entnehmen.

Bei dem vorgeschlagenen Verfahren zur Überwachung des Durchbruchs von pn-Übergängen in Halbleiterbauteilen wird mit einem in der Umgebung des pn-Übergangs in das Halbleiterbauteil integrierten photosensitiven elektronischen Bauelement optische Strahlung erfasst, die der pn-Übergang während eines Durchbruchs emittiert. In Abhängigkeit dieser erfassten Strahlung wird dann eine an den pn-Übergang angelegte Spannung oder ein über den pn-Übergang geleiteter Strom geregelt. Die Regelung kann derart erfolgen, dass ein vollständiger Durchbruch des pn-Übergangs verhindert wird. Bei Ansteigen der optischen Emission des pn-Übergangs über eine vorgebbare Schwelle wird in diesem Fall der Strom oder die Spannung am pn-Übergang verringert, bis die optische Emission wieder unter den Schwellwert gefallen ist oder nicht weiter ansteigt. Unter einem vollständigen Durchbruch wird in diesem Zusammenhang ein Durchbruch mit einer Dauer verstanden, die zu Überhitzung oder Zerstörung des Halbleiterbauteils führt.

Das vorgeschlagene Halbleiterbauteil umfasst zumindest den zu überwachenden pn-Übergang, eine Regelungseinheit zur Regelung einer an den pn-Übergang angelegten Spannung oder eines über den pn-Übergang geleiteten Stroms und ein mit der Regelungseinheit verbundenes photosensitives elektronisches Bauelement. Das photosensitive Bauelement ist dabei derart in der Umgebung des pn-Übergangs integriert, dass es während eines Durchbruchs am pn-Übergang emittierte optische Strahlung erfassen kann. Die Regelungseinheit ist so ausgebildet, das sie die an den pn-Übergang angelegte Spannung oder den über den pn-Übergang geleiteten Strom in Abhängigkeit der erfassten Strahlung regelt.

Das vorliegende Verfahren ermöglicht die Selbstüberwachung des Durchbruchs an einem pn-Übergang in einem Halbleiterbauteil, ohne den Betriebsbereich des Halbleiterbauteils dadurch weiter einzuschränken. Vielmehr lässt sich damit das Halbleiterbauteil mit Spannungen oder Strömen kurz vor dem Einsetzen des Durchbruchs betreiben, so dass eine erhöhte Leistungsausbeute erzielbar ist. Das Verfahren eignet sich hierbei insbesondere für die Selbstüberwachung des Durchbruchs in schnellen ICs und schnellen Halbleiterbauelementen während ihres bestimmungsgemäßen Betriebs. Wesentliche Vorteile des Verfahrens und des Halbleiterbauteils bestehen daher in einem vergrößerten Betriebsbereich und einer erhöhten Leistung des Halbleiterbauteils, in einem größeren Temperaturbereich für den Betrieb, einer größeren Akzeptanz von Bauelementstreuungen und einem Schutz vor Zerstörung und somit Ausfall des Halbleiterbauteils.

Bei dem vorliegenden Verfahren und dem dafür ausgestalteten Halbleiterbauteil wird die Erkenntnis genutzt, dass während des Durchbruchs eines pn-Übergangs sichtbares Licht emittiert wird. Die Lichtemission steigt im Verlauf des Durchbruchs an, so dass sie als Signal für den einsetzenden Durchbruch sowie als Maß für einen fortschreitenden Durchbruch herangezogen werden kann. Beim vorliegenden Verfahren und dem zugehörigen Halbleiterbauteil wird daher ein photosensitives elektronisches Bauelement, vorzugsweise eine Photodiode, nahe am Erzeugungsort der Lichtemission, d. h. nahe am zu überwachenden pn-Übergang, in das Halbleiterbauteil integriert. Der Ort dieses photosensitiven Bauelementes muss dabei ausreichend nahe am pn-Übergang gewählt werden, da die Lichtemission nur schwach ist und zudem im Halbleitermaterial stark absorbiert wird. Das von dem photosensitiven Bauelement gemessene Signal, im Fall der Photodiode der Photostrom, wird zur Regelung der Versorgung (Spannung, Strom) des zu schützenden Bauelementes bzw. pn-Übergangs verwendet.

Bei dem vorgeschlagenen Verfahren wird somit die schwache und bisher als nutzlos betrachtete Lichtemission beim Durchbruch eines pn-Übergangs als Selbsttest für den Durchbruch während des Betriebs des Halbleiterbauteils genutzt. Das hierzu integrierte photosensitive Bauelement dient ausschließlich der Erfassung dieser Lichtemission für die Regelung der Versorgung des überwachten Halbleiterbauelements.

Selbstverständlich können mit dem vorgeschlagenen Verfahren auch mehrere pn-Übergänge in einem Halbleiterbauteil, bspw. einer komplexen integrierten Schaltung, überwacht werden. In diesem Falle ist an jedem zu überwachenden pn-Übergang ein entsprechendes photosensitives Bauelement integriert und mit einer die Versorgung des Halbleiterbauelements des überwachten pn-Überganges regelnden Regelungseinheit verbunden.

Bei dem zu regelnden Bauelement kann es sich beispielsweise um einen Bipolartransistor, einen Heterobipolartransistor (HBT) oder um einen Feldeffekttransistor (FET), insbesondere einen MOSFET, handeln. Bei einem Feldeffekttransistor wird vorzugsweise das Regelsignal der Regelungseinheit zur Steuerung der Source-Bulk oder Source-Drain oder Gate-Source Spannung benutzt.

An die Regelungseinheit selbst werden keine besonderen Anforderungen gestellt. Diese Regelungseinheit muss lediglich schnell genug die Spannung oder den Strom regeln können, um den Durchbruch zu verhindern. Als Regelungstechniken können hierbei bspw. eine PI-oder eine PID-Regelung zum Einsatz kommen. Die Regelungseinheit selbst ist dabei vorzugsweise ebenfalls, wie auch das photosensitive Bauelement, monolithisch in das Halbleiterbauteil integriert.

### Kurze Beschreibung der Zeichnungen

Das vorgeschlagene Verfahren sowie das Halbleiterbauteil werden nachfolgend anhand eines Ausführungsbeispiels in Verbindung mit den Zeichnungen nochmals kurz erläutert. Hierbei zeigen:
- Fig. 1: ein Beispiel für die Integration einer Photodiode in einen Heterobipolartransistor zur Durchführung des vorgeschlagenen Verfahrens; und
- Fig. 2: schematisch den prinzipiellen Aufbau eines Halbleiterbauteils gemäß der vorliegenden Erfindung.

### Wege zur Ausführung der Erfindung

Im folgenden Beispiel wird das vorgeschlagene Verfahren sowie der Aufbau eines entsprechend ausgestalteten Halbleiterbauteils am Beispiel eines Heterobipolartransistors nochmals erläutert. Der Durchbruch des pn-Übergangs im Heterobipolartransistor soll dabei während des normalen Betriebs dieses Transistors durch das Halbleiterbauteil selbst überwacht werden, um einen Durchbruch während des Betriebs zu verhindern. Bei dem Verfahren erfolgt eine in situ Detektion des Lichtes, das von dem Halbleitermaterial im Lawinendurchbruch am pn-Übergang emittiert wird. Dieses Leuchten wird mit einem monolithisch integrierten Photodetektor, der nahe am pn-Übergang platziert ist, in einen Photostrom gewandelt. Der Photostrom wird als Regelsignal für die Versorgung des Heterobipolartransistors genutzt.

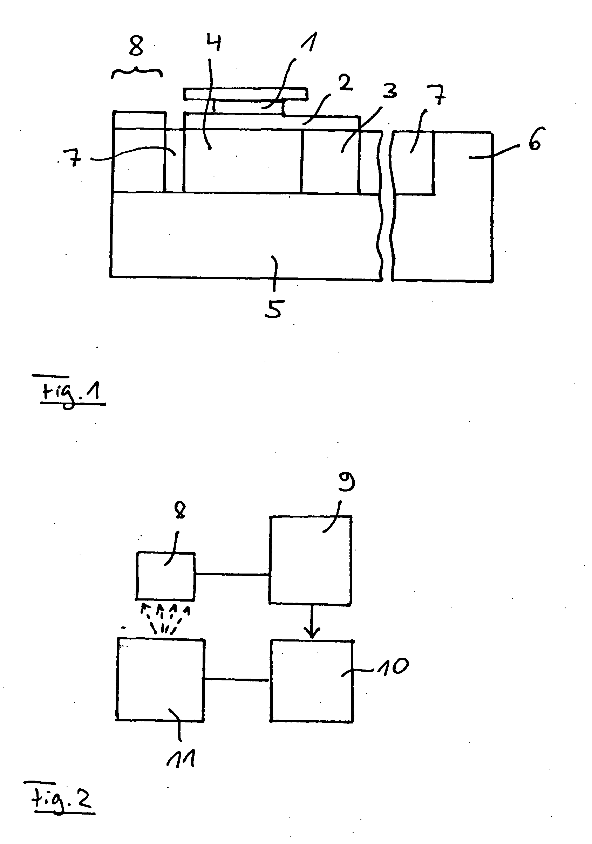

In Figur 1 ist hierbei der bekannte Aufbau eines Heterobipolartransistors dargestellt, mit dem Emitter 1, der Basis 2, dem Kollektor 3, dem SIC-Kollektorbereich 4 (SIC: Selectively Implanted Collector), dem darunter liegenden Subkollektor 5 und dem Kollektoranschluss 6. Der obere Bereich dieses Heterobipolartransistors ist von einem Trenchgraben mit einem Isolator 7 umgeben.

Für die Erfassung des während eines Durchbruchs von dem zu überwachenden pn-Übergang zwischen Basis und Kollektor ausgesendeten Licht ist in der Nähe dieses Übergangs, in Figur 1 im linken Teil, eine Photodiode 8 integriert, deren pn-Übergang ebenfalls in der Figur erkennbar ist. Diese Photodiode 8 ist mit einer in Figur 1 nicht dargestellten Regelungseinheit verbunden, die den Basisstrom des Heterobipolartransistors in Abhängigkeit vom Photostrom der Photodiode 8 regelt.

Die Regelschleife hält den für das zu überwachende Halbleiterbauelement bestimmenden Eingangsparameter, d. h. den Basisstrom bei dem hier beispielhaft dargestellten Heterobipolartransistor, auf einem definierten Wert in oder kurz vor dem Durchbruch. Im Falle eines MOSFET als zu überwachendem Bauelement kann beispielsweise die Gatespannung als bestimmender Eingangsparameter geregelt werden.

Das Bauelement kann hierbei sowohl am Beginn des Durchbruchs oder aber im Durchbruch gehalten werden. Die Festlegung des Arbeitspunktes für die Regelung ist dem Hersteller oder dem Anwender überlassen. Das vorgeschlagene Verfahren lässt sämtliche Möglichkeiten zu.

Figur 2 zeigt schematisch die Regelungseinheit 9, die Photodiode 8 sowie die Versorgung 10 für das zu überwachende Halbleiterbauelement 11. Der in der Photodiode 8 erzeugte Photostrom kann im vorliegenden Beispiel des Heterobipolartransistors zur Regelung im einfachsten Fall auf die Basis 2 als zweiter Stromanteil (mit invertiertem Vorzeichen) gegeben werden. Selbstverständlich ist jedoch auch eine PID-Regelung des Basisstromes möglich, wobei der Photostrom der Photodiode 8 als Regelsignal verwendet wird.

Bei dem vorgeschlagenen Verfahren wird das von Halbleiterbauelement, das eine Qualitätsprüfung bereits bestanden hat, im Betrieb ausgesendete Licht mittels eines integrierten Photodetektors erfasst und das detektierte Signal zur Regelung des Arbeitspunktes des Halbleiterbauelementes verwendet. Diese Regelung kann bei zukünftigen Oszillatorschaltungen verwendet werden, um mehr Leistung mit den Transistoren zu erzeugen, da diese mit dem Verfahren ohne Gefahr einer Zerstörung definiert im Durchbruch betrieben werden können.

### Bezugszeichenliste

- 1: Emitter
- 2: Basis
- 3: Kollektor
- 4: SIC-Kollektor
- 5: Sub-Kollektor
- 6: Kollektoranschluss
- 7: Isolator
- 8: Photodiode
- 9: Regelungseinheit
- 10: Versorgung
- 11: Halbleiterbauelement

## Patentansprüche

1. Verfahren zur Überwachung eines Durchbruchs von pn-Übergängen in Halbleiterbauteilen, bei dem mit einem in der Umgebung eines zu überwachenden pn-Übergangs in das Halbleiterbauteil integrierten photosensitiven elektronischen Bauelement (8) optische Strahlung erfasst wird, die der pn-Übergang im Falle des Durchbruchs emittiert, und eine an den pn-Übergang angelegte Spannung oder ein über den pn-Übergang geleiteter Strom in Abhängigkeit der erfassten Strahlung geregelt wird.

2. Verfahren nach Anspruch 1,
bei dem die an den pn-Übergang angelegte Spannung oder der über den pn-Übergang geleitete Strom in Abhängigkeit der erfassten Strahlung so geregelt wird, dass ein vollständiger Durchbruch des pn-Übergangs verhindert wird.

3. Verfahren nach Anspruch 1,
bei dem die an den pn-Übergang angelegte Spannung oder der über den pn-Übergang geleitete Strom in Abhängigkeit der erfassten Strahlung geregelt wird, um den Durchbruch des pn-Übergangs gezielt zu steuern.

4. Verfahren nach einem der Ansprüche 1 bis 3,
bei dem die optische Strahlung mit einer in das Halbleiterbauteil integrierten Photodiode erfasst wird.

5. Verfahren nach einem der Ansprüche 1 bis 4,
bei dem die Überwachung und Regelung durch das Halbleiterbauteil selbst während des bestimmungsgemäßen Betriebs erfolgt.

6. Verfahren nach einem der Ansprüche 1 bis 5 zur Überwachung des Durchbruchs von pn-Übergängen in integrierten Schaltungen.

7. Halbleiterbauteil mit zumindest
- einem pn-Übergang,
- einer Regelungseinheit (9) zur Regelung einer in Sperrrichtung an den pn-Übergang angelegten Spannung oder eines in Sperrrichtung über den pn-Übergang geleiteten Stroms und
- einem mit der Regelungseinheit (9) verbundenen photosensitiven elektronischen Bauelement (8), wobei das photosensitive elektronische Bauelement so in der Umgebung des pn-Übergangs in das Halbleiterbauteil integriert ist, dass es während eines Durchbruchs am pn-Übergang emittierte optische Strahlung erfassen kann, und die Regelungseinheit (9) die in Sperrrichtung an den pn-Übergang angelegte Spannung oder den in Sperrrichtung über den pn-Übergang geleiteten Strom in Abhängigkeit der erfassten Strahlung regelt.

8. Halbleiterbauteil nach Anspruch 7,
bei dem die Regelungseinheit (9) so ausgebildet ist, dass sie durch die Regelung einen vollständigen Durchbruch des pn-Übergangs verhindert.

9. Halbleiterbauteil nach Anspruch 7,
bei dem die Regelungseinheit (9) so ausgebildet ist, dass sie durch die Regelung den Durchbruch gezielt nach einer Vorgabe steuert.

10. Halbleiterbauteil nach einem der Ansprüche 7 bis 9,
bei dem das photosensitive elektronische Bauelement (8) eine Photodiode ist.

11. Halbleiterbauteil nach einem der Ansprüche 7 bis 10, bei dem der pn-Übergang in einem Bipolartransistor ausgebildet ist.

12. Halbleiterbauteil nach einem Anspruch 7 bis 10, bei dem der pn-Übergang in einem Heterobipolartransistor (HBT) ausgebildet ist.

13. Halbleiterbauteil nach einem Anspruch 7 bis 10, bei dem der pn-Übergang in einem Feldeffekttransistor (FET), insbesondere einem MOSFET, ausgebildet ist.

14. Halbleiterbauteil nach einem Anspruch 13, bei dem die Regelungseinheit (9) zur Steuerung einer Source-Bulk oder Source-Drain oder Gate-Source Spannung des Feldeffekttransistors ausgebildet ist.

## Claims

1. Method for monitoring a breakdown of pn-junctions in semiconductor components, in which, optical radiation, which the pn-junction emits in the case of the breakdown, is detected with a photosensitive electronic component (8) integrated into the semiconductor component in the vicinity of the pn-junction to be monitored, and a voltage applied at the pn-junction or a current conducted across the pn-junction is controlled in dependence on the radiation detected.

2. Method according to Claim 1,
in which the voltage applied at the pn-junction or the current conducted across the pn-junction is controlled in dependence on the radiation detected in such a manner that a complete breakdown of the pn-junction is prevented.

3. Method according to Claim 1,
in which the voltage applied at the pn-junction or the current conducted across the pn-junction is controlled in dependence on the radiation detected in order to control the breakdown of the pn-junction in a targeted manner.

4. Method according to one of Claims 1 to 3,
in which the optical radiation is detected with a photodiode integrated into the semiconductor component.

5. Method according to one of Claims 1 to 4, in which the monitoring and control takes place by means of the semiconductor component itself during normal operation.

6. Method according to one of Claims 1 to 5 for monitoring the breakdown of pn-junctions in integrated circuits.

7. Semiconductor component with at least
- one pn-junction,
- one control unit (9) for controlling a voltage applied in reverse direction at the pn-junction or a current conducted in reverse direction across the pn-junction and
- one photosensitive electronic component (8) connected to the control unit (9), wherein the photosensitive electronic component is integrated into the semiconductor component in the vicinity of the pn-junction in such a manner that it can detect optical radiation emitted at the pn-junction during a breakdown, and the control unit (9) controls the voltage applied in reverse direction at the pn-junction or the current conducted in reverse direction across the pn-junction in dependence on the radiation detected.

8. Semiconductor component according to Claim 7,
in which the control unit (9) is constructed such that it prevents a complete breakdown of the pn-junction by means of the control.

9. Semiconductor component according to Claim 7,
in which the control unit (9) is constructed such that it controls the breakdown in a targeted manner in accordance with a stipulation by means of the control.

10. Semiconductor component according to one of Claims 7 to 9,
in which the photosensitive electronic component (8) is a photodiode.

11. Semiconductor component according to one of Claims 7 to 10, in which the pn-junction is formed in a bipolar transistor.

12. Semiconductor component according to one of Claims 7 to 10, in which the pn-junction is formed in a heterobipolar transistor (HBT).

13. Semiconductor component according to one of Claims 7 to 10, in which the pn-junction is formed in a field effect transistor (FET), particularly a MOSFET.

14. Semiconductor component according to Claim 13, in which the control unit (9) is designed to control a source bulk or source drain or gate source voltage of the field effect transistor.

## Revendications

1. Procédé pour surveiller une rupture de jonctions pn dans des composants à semi-conducteur, avec lequel on détecte un rayonnement optique avec un composant électronique photosensible intégré dans le composant à semi-conducteur (8) dans l'environnement d'une jonction pn à surveiller, lequel rayonnement est émis par la jonction pn en cas de rupture, et une tension appliquée à la jonction pn ou bien un courant conduit via la jonction pn étant régulé(e) en fonction du rayonnement détecté.

2. Procédé selon la revendication 1,
avec lequel la tension appliquée à la jonction pn ou bien le courant conduit via la jonction pn est régulé(e) en fonction du rayonnement détecté de manière à éviter une rupture complète de la jonction pn.

3. Procédé selon la revendication 1,
avec lequel la tension appliquée à la jonction pn ou bien le courant conduit via la jonction pn est régulé(e) en fonction du rayonnement détecté afin de commander de manière ciblée la rupture de la jonction pn.

4. Procédé selon l'une des revendications 1 à 3,
avec lequel on détecte le rayonnement optique avec une photodiode intégrée dans le composant à semi-conducteur.

5. Procédé selon l'une des revendications 1 à 4,
avec lequel la surveillance et la régulation s'effectuent grâce au composant à semi-conducteur même pendant le fonctionnement conforme.

6. Procédé selon l'une des revendications 1 à 5 pour la surveillance de la rupture de jonctions pn dans des circuits intégrés.

7. Composant à semi-conducteur avec au moins
- une jonction pn,
- une unité de régulation (9) pour réguler une tension appliquée en direction de verrouillage à la jonction pn ou bien un courant conduit en direction de verrouillage via la jonction pn et
- un composant électronique photosensible (8) en liaison avec l'unité de régulation (9), le composant électronique photosensible étant intégré dans l'environnement de la jonction pn dans le composant à semi-conducteur de manière à pouvoir détecter un rayonnement optique émis pendant une rupture à la jonction pn, et l'unité de régulation (9) régulant la tension appliquée en direction de verrouillage à la jonction pn ou bien le courant conduit en direction de verrouillage via la jonction pn en fonction du rayonnement détecté.

8. Composant à semi-conducteur selon la revendication 7,
avec lequel l'unité de régulation (9) est conçue de manière à éviter une rupture complète de la jonction pn grâce à la régulation.

9. Composant à semi-conducteur selon la revendication 7, avec lequel l'unité de régulation (9) est conçue de façon à commander de manière ciblée la rupture d'après une spécification grâce à la régulation.

10. Composant à semi-conducteur selon l'une des revendications 7 à 9,
avec lequel le composant électronique photosensible (8) est une photodiode.

11. Composant à semi-conducteur selon l'une des revendications 7 à 10,
avec lequel la jonction pn est réalisée dans un transistor bipolaire.

12. Composant à semi-conducteur selon l'une des revendications 7 à 10,
avec lequel la jonction pn est réalisée dans un transistor hétéro-bipolaire (HBT).

13. Composant à semi-conducteur selon l'une des revendications 7 à 10,
avec lequel la jonction pn est réalisée dans un transistor à effet de champ (FET), en particulier un MOSFET.

14. Composant à semi-conducteur selon la revendication 13,
avec lequel l'unité de régulation (9) est réalisée pour la commande d'une tension de source-substrat ou source-drain ou grille-source du transistor à effet de champ.
